# EUROPEAN PATENT SPECIFICATION

(11) **EP 4 213 386 B1**
(45) Date of publication and mention of the grant of the patent: **25.02.2026**
(21) Application number: 22151383.1
(22) Date of filing: 13.01.2022
(51) Int. Cl.: H03K 17/12, H03K 17/082, G01R 19/00, H01L 23/00, H01L 25/07, H01L 25/16

(54) **SEMICONDUCTOR ASSEMBLY WITH SEMICONDUCTOR SWITCHING DEVICE AND CURRENT SENSE UNIT**
HALBLEITERANORDNUNG MIT HALBLEITERSCHALTVORRICHTUNG UND STROMMESSEINHEIT
ENSEMBLE SEMICONDUCTEUR DOTÉ D'UN DISPOSITIF DE COMMUTATION À SEMICONDUCTEUR ET UNITÉ DE DÉTECTION DE COURANT

(43) Date of publication of application: 19.07.2023
(73) Proprietor: Infineon Technologies AG, 85579 Neubiberg (DE)
(72) Inventor: MAUDER, Anton, 83059 Kolbermoor (DE); RUZZA, Stefano, 27035 Mede (Pavia) (IT); GRASSO, Massimo, 27020 Trivolzio (IT); KUCHCINSKI, Richard, 59581 Warstein (DE); DOMES, Daniel, 59602 Ruethen (DE)
(74) Representative: Müller Hoffmann & Partner

(56) References cited:
- US-A- 5 153 696
- US-A1- 2007 085 135
- US-A1- 2016 141 403
- US-A1- 2018 234 093

## Description

### TECHNICAL FIELD

Examples of the present disclosure relate to a semiconductor assembly with a semiconductor switching device and a current sense unit. In particular, the present disclosure relates to power modules having a plurality of semiconductor switching devices electrically connected in parallel.

Fast overcurrent detection is critical to limit power losses and prevent destruction of power semiconductor switches. A maximum delay between the occurrence of an overload condition and the termination of the overcurrent condition must not exceed a few microseconds.

Typical current sensing power MOSFETs (metal oxide semiconductor field effect transistors) use a mirror principle based on the fact that individual transistor cells of a power MOSFET are well matched. Therefore, a current mirror ratio between transistor cells of a power section and transistor cells of a sense section is inverted to the on-resistance ratio between the power section and the sense section. The total load current can then be determined by measuring the on-state current through the sense section and multiplying the measured sense current by the current mirror ratio.

For this purpose, the source of the sense section is connected to a separate sense pin. Then, when the current sensing power MOSFET is turned on, the current flow splits inversely with respect to the two resistances. In typical current-sensing power MOSFETs, the current mirror ratio between the transistor cells in the power section (source cells) and the transistor cells in the sense section (mirror cells) is on the order of, e.g., 1000:1 or even higher. The sense current can be determined by measuring a voltage across a sense resistor connecting the sense pin and the source. The resistance of the sense resistor affects the current mirror ratio.

Document US 5 153 696 describes a MOSFET in which the greater number of cells is connected in parallel to form a power MOFET and some other cells are connected in parallel to form a current sensing element. The source regions of all the cells of the power MOSFET are connected to a source pad and a Kelvin pad. The source regions of the current sensing element are connected to a Miller pad. A resistor element for the sensing current is arranged between the source electrode of the power MOFSET and the Miller pad. The resistor element for the sensing current is integrated into the MOSFET between the Kelvin pad and the Miller pad, both of which are formed on the MOSFET. The package of the MOSFET shields the resistor element against external noise adversely affecting the sense current measurement.

Document US 2007 / 0 085 135 A1 describes an IGBT with a resistor layer between collector layer and collector electrode. A sense collector electrode is in direct contact with the collector layer. The IGBT load current can be determined from the electrical resistance of the resistor layer and the potential difference between the collector electrode and the sense collector electrode.

There is a need for semiconductor assemblies with easy-to-implement and accurate load current sensing.

### SUMMARY

A semiconductor assembly according to the invention is defined in the appended independent claim. Preferred embodiments are defined in the dependent claims.

### BRIEF DESCRIPTION OF THE DRAWINGS

The accompanying drawings are included to provide a further understanding of the embodiments and are incorporated in and constitute a part of this application. The drawings illustrate embodiments of a semiconductor assembly and together with the description serve to explain principles of the embodiments. Further embodiments are described in the following detailed description and the claims.
FIGS. 1A-1B illustrate a schematic plan view and a schematic cross-sectional view of a portion of a semiconductor assembly having a current sense unit electrically connected between a load pad of a semiconductor switching device and a conductive load base structure according to an embodiment.
FIG. 2 illustrates a schematic block diagram of a portion of a semiconductor assembly according to an embodiment related to a current sense unit based on a resistive shunt.
FIG. 3 illustrates a schematic block diagram of a portion of a semiconductor assembly according to an embodiment related to a current sense unit based on a magnetic field sensor.
FIG. 4 illustrates a schematic plan view of a semiconductor assembly having a current sense unit electrically connected between two load pads of a semiconductor switching device according to an embodiment.
FIG. 5 illustrates a schematic plan view of a semiconductor assembly having a current sense unit electrically connected between a portion of a divided load pad and a conductive load base structure according to an embodiment.
FIG. 6 illustrates a schematic plan view of a semiconductor assembly having a current sense unit electrically connected between two load pads of a semiconductor switching device according to an embodiment related to additional pad connections.
FIG. 7 illustrates a schematic plan view of a semiconductor assembly having a current sense unit electrically connected between a portion of a divided load pad and another load pad.
FIG. 8 illustrates a schematic plan view of a semiconductor assembly with semiconductor switching devices with and without connection to a current sense unit according to a further embodiment.
FIG. 9 illustrates a schematic plan view of a semiconductor assembly with each of a plurality of semiconductor switching devices connected to a current sense unit according to a further embodiment.

### DETAILED DESCRIPTION

In the following detailed description, reference is made to the accompanying drawings, which form a part hereof and in which are shown by way of illustrations specific embodiments in which a semiconductor assembly, in particular an IGBT (insulated gate bipolar transistor) power module, may be practiced. It is to be understood that other embodiments may be utilized and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive connection between electrically connected elements, for example a direct, ohmic contact between the concerned elements or a low-resistive connection via a metal and/or heavily doped semiconductor material. An ohmic contact is a non-rectifying electrical junction with a linear or almost linear current-voltage characteristic. The terms "electrically coupled" and "signal-connected" include that one or more intervening element(s) adapted for signal and/or power transmission may be connected between the electrically coupled elements, for example, elements that are controllable to temporarily provide a low-resistive connection in a first state and a high-resistive electric decoupling in a second state.

Ranges given for physical dimensions include the boundary values. For example, a range for a parameter y from a to b reads as a ≤ y ≤ b. The same holds for ranges with one boundary value like "at most" and "at least".

Main constituents of a layer or a structure from a chemical compound or alloy are such elements which atoms form the chemical compound or alloy. For example, copper and aluminum are main constituents of a copper aluminum alloy.

The term "on" is not to be construed as meaning "directly on". Rather, if one element is positioned "on" another element (e.g., a layer is "on" another layer or "on" a substrate), a further component (e.g., a further layer) may be positioned between the two elements (e.g., a further layer may be positioned between a layer and a substrate if the layer is "on" said substrate).

As regards structures and doped regions formed in a substrate, a second region is "below" a first region, if a minimum distance between the second region and a first substrate main surface at the front side of the substrate is greater than a maximum distance between the first region and the first substrate main surface. The second region is "directly below" the first region, where the vertical projections of the first and second regions into the first substrate main surface overlap. The vertical projection is a projection orthogonal to the first substrate main surface.

A safe operating area (SOA) defines voltage and current conditions over which a semiconductor device can be expected to operate without self-damage. The SOA is given by published maximum values for device parameters like maximum continuous load current, maximum gate voltage and others.

The term "power semiconductor device" refers to semiconductor devices with high voltage blocking capability of at least 30V, e.g. 100V, 600V, 3.3kV or more and with a nominal on-state current or forward current of at least 1A, e.g. 10A or more.

A semiconductor die includes the semiconducting portions of a semiconductor device and further structures typically formed at wafer level. For example, the semiconductor die may include a front side metallization at a front side and a back side metallization at a side opposite to the front side. The front side metallization may include one or more metal pads. A load current may flow from the metal pads through the semiconductor die to the back side metallization or from the back side metallization to the metal pads.

A semiconductor device includes at least one semiconductor die and at least one further structure typically formed after separation of the semiconductor die from a wafer composite. For example, a semiconductor device may include a semiconductor die, terminals, and bond wires connecting the terminals with the metal pads on the semiconductor die.

An embodiment of the present disclosure relates to a semiconductor assembly that may include a semiconductor switching device, a conductive load base structure and a current sense unit. The semiconductor switching device may include a drain structure and one or more array units, wherein each array unit includes a load pad and a plurality of transistor cells electrically connected in parallel between the load pad of the array unit and the drain structure. The current sense unit is electrically connected between a first one of the load pads and the load base structure.

The semiconductor assembly may include several power components, e.g. power semiconductor devices such as semiconductor switches, diodes, sensors, protection circuits, and/or control circuits. For example, the semiconductor assembly may be a power module including a power electronic substrate and semiconductor devices provided as bare semiconductor dies attached to the power electronic substrate, e.g. by soldering or sintering. The power electronic substrate may be a PCB (printed circuit board) or a DBC (direct bonded copper) substrate. The power module may include the electronic components of a bridge rectifier, a half bridge, an H-bridge, a full bridge (poly-phase bridge), a PFC (power factor correction) circuit, a PIM (power integrated module) or an IPM (intelligent power module), by way of example.

The semiconductor switching device may be a silicon MOSFET, a silicon IGBT, e.g. a reverse-conducting IGBT (RC-IGBT), or a semiconductor switch from a wide band gap material, e.g. a SiC MOSFET (silicon carbide MOSFET) or a GaN HEMT (gallium nitride high electron mobility transistor).

In particular for silicon and silicon carbide switching devices, the drain structure may include a horizontal drift layer of a conductivity type corresponding to the channel type of the transistor cells. The drift layer may be comparatively lightly doped. For transistor cells with electron channel (n-channel), the drift layer is n conductive and for transistor cells with hole channel (p-channel) the drift layer is p conductive. The semiconductor switching device may further include a metal rear side electrode. For MOSFETs, a heavily doped contact layer of the conductivity type of the drift layer electrically connects the drain structure with the rear side electrode. For IGBTs, a heavily doped contact layer with a conductivity type opposite to that of the drift layer or with zones of both conductivity types electrically connects the drain structure with the rear side electrode. The drain structure may include a more heavily doped layer of the conductivity type of the drift layer between the drift layer and the contact layer.

The number of transistor cells is a function of the nominal output current of the semiconductor switching device. The transistor cells can be grouped in several array units, e.g. to enable control signals arriving at each of the transistor cells within limited delay time. The array units have a same vertical configuration and include the same type of transistor cells. In particular, the transistor cells of all array units are matched and have the same lateral dimensions, the same center-to-center distances to neighboring transistor cells and the same electrical target parameters. The gate electrodes of the transistor cells of all array units may be electrically connected with each other.

The number of array units is a function of the nominal output current of the semiconductor switching device and may be in a range from 1 to about 20.

The load pads are formed at a front side of the semiconductor device. Vertical and lateral dimensions of each load pad and internal configuration of each load pad are such that each load pad forms a suitable wire bond base for wire bonding. The semiconductor device may include two or more load pads, e.g. four, six, eight or more. The load pads are laterally separated from each other. In particular, the first load pad is laterally separated from all second load pads. The second load pads may lack or may have a conductive connection formed, e.g. by a metal structure at the front side of the semiconductor device.

The lateral cross-sectional area of each load pad may be sufficiently large for providing a suitable base for a bond wire connection that carries a current of at least 100mA, of at least 500mA, or even several Ampere. In each array unit, the transistor cells are formed directly below the load pad of the array unit, wherein a density of the transistor cells may be approximately the same in all array units.

In particular, the first load pad and all second load pads have the same vertical configuration. The first load pad is used as sense pad. The current tapped from the first load pad represents the sense current.

The load base structure can be or include a metal structure formed on the surface of the power electronic substrate, e.g. a flat copper plate formed on a resin substrate.

The current sense unit may measure the sense current by measuring a voltage drop caused by the sense current across a low-ohmic shunt, by measuring a voltage induced by the magnetic field around a conductor through which the sense current flows and/or by using current compensation.

The sense current is a portion of the load current tapped from an arbitrary one of the load pads and diverted through the current sense unit. The lateral area of the load pad corresponds to the lateral area and the total channel width of the corresponding array unit such that the sense current can be tailored by the size of the first load pad, wherein the sense current tapped from the first load pad may be in the same order of magnitude as the total load current or one magnitude lower than the total load current.

In particular, the sense current is comparatively high and can be at least 1% at least 5%, at least 10% or 100% of the total load current in case of a semiconductor switching device with one single load pad
Similar to typical current sensing power MOSFETs, the present embodiment uses a mirror principle based on the fact that the on-state resistances of the individual transistor cells in a power MOSFET are well matched so that a load/sense current ratio is equal to the ratio of the on-state resistance of one of the array units and the other array units. Then the total load current IL can be determined by multiplying the measured sense current IS by the load/sense current ratio.

A typical current sensing power MOFET includes a sense pin ("mirror pin") connected to the sources of the sense transistor cells. A sense resistor is connected between the sense pin and a load pin connected to the sources of the load transistor cells. The sense current is determined by measuring a voltage drop across the sense resistor. Since a high sense resistance affects the current mirror ratio, a low sense resistance is typically selected so that the sense current in the on-state produces only a comparatively small voltage drop across the sense resistor. On the other hand, the load/sense current ratio between the load transistor cells and the sense transistor cells is on the order of 1000:1 so the sense current is low.

Therefore, even a short-circuit current generates only a low voltage across the sense resistor and it is difficult to distinguish between actual critical overload conditions and non-critical voltage transients caused, for example, by stray capacitance charging or coupling from noisy circuit environment.

Input filter can suppress voltage transients but also delay the detection of actual critical overload conditions. Active circuits to match the potentials at the sources of the load transistor cells and at the sources of the sense transistor cells require complex and expensive additional circuitry. Furthermore, the sense pad requires additional area on the front side of the semiconductor device, wherein the additional area required for the sense pad may be significantly larger than the area of the sense transistor cells.

On the other hand, a much higher fraction of the total load current is tapped as sense current in the semiconductor assembly according to the embodiments. The sense current may be greater than 100mA, e.g. greater than 500mA or greater than 1A. The comparatively high sense current produces a comparatively high voltage drop even if a small sense resistance is used. True overcurrent events can be more easily distinguished from non-critical transient current spikes. Accordingly, the L*dI/dt of the sense current is much closer to the L*dI/dt of the total load current than in such current sensing power MOSFTs, where the sense current is typically less than 1/1000 of the load current. The dynamic response of the sense current can more reliably reflect the dynamic response of the total load current.

The evaluation of overcurrent events is more reliable against noise. No additional sensor pad or sensor pin is required on the semiconductor device, which is designed only to tap the sense current. That is, no additional chip design is required to implement the sensing option. The same semiconductor device can be used with or without the sense option. Applications based on current sensing (e.g. overcurrent detection) can be implemented with little additional effort and complexity.

According to an embodiment, the transistor cells may be formed directly between the load pad and the drain structure in each array unit.

In particular, the transistor cells of each array unit may be formed completely within the contour of the load pad of the concerned array unit, so that all transistor cells of the same array unit are formed directly below the load pad of the array unit. In other words, the transistor cells of an array unit are formed within a vertical projection of the load pad of the array unit.

According to an embodiment, the current sense unit may include a resistive shunt electrically connected between the first load pad and the load base structure or between the first load pad and one of the second load pads.

The resistance of the resistive shunt can be greater than 1mΩ, and less than 50mΩ, e.g. in a range from 1mΩ to 20mΩ. A typical voltage drop across the resistive shunt in the on-state of the semiconductor device may be in a range of 10mV to 40mV at typical operating currents. In the event of an overcurrent event or a short circuit, the voltage drop can increase by a factor between 2 and 10.

The resistive shunt may include a metal line at a thickness of 1µm to 20µm on a surface of a semiconductor die of the current sense unit. The metal line may contain or consist of aluminum Al or copper Cu. A width of a metal line from copper may be about 150µm for an expected overcurrent of 10A. The length of the metal line may be about 1mm, wherein the metal line can be straight or can form a meander line.

According to an embodiment, the current sense unit may include a magnetic field sensor configured to sense a magnetic field caused by a current flowing between the first load pad and the load base structure or between the first load pad and one of the second load pads.

The magnetic field sensor may include a magnetic Hall Effect sensor or a sensor based on a magneto resistance effect, e.g. a GMR (giant magnetoresistance) sensor or a TMR (tunnel magnetoresistance) sensor, by way of example.

According to an embodiment, the semiconductor assembly may further include one or more load connection structures, wherein each load connection structure electrically connects the load base structure and one or more second ones of the load pads.

In particular, each load connection structure may include one or more bond wires, each of them with at least one bond foot formed directly on at least one second load pad and with at least one bond foot formed directly on the load base structure.

According to an embodiment, at least one of the load connection structures may electrically connect the load base structure and two of the second load pads.

In particular, each load connection structure may include one or more bond wires with at least one bond foot formed directly on each of the second load pads connected to the load connection structure and with at least one bond foot formed directly on the load base structure.

According to an embodiment, the semiconductor assembly may further include a gate pad and gate connection lines. The gate pad is laterally separated from the load pads. The gate connection lines may be electrically connected with the gate pad and are formed in pad gaps between neighboring ones of the load pads.

The gate connection lines distribute the gate signal evenly among the transistor cells and avoid large differences in propagation times. The gate connection lines divide a front side of the switching device semiconductor die into array units of approximately the same size. The load pad formed in one of the array units can be used as sense pad without redesigning of the metallization layout.

In particular, semiconductor switching devices with gate pad and gate connection lines formed in pad gaps between adjacent load pads can be used without modification for the present embodiments.

According to an embodiment, a first terminal of the current sense unit may be directly connected to the first load pad and a second terminal of the current sense unit may be directly connected to the load base structure.

According to another embodiment, a first terminal of the current sense unit may be directly connected to the first load pad and a second terminal of the current sense unit may be directly connected to one of the second load pads.

In this way, the parasitic inductance effective for the sense current can be better matched with the parasitic inductance effective for the load current and the dynamic response of the sense current is better matched with the dynamic response of the load current.

According to an embodiment, the current sense unit may include an overcurrent detection circuit configured to evaluate a current flowing through the current sense unit between the first load pad and the load base structure or between the first load pad and one of the second load pads.

By tapping a comparatively high sense current at one of the load pads, the overcurrent detection circuit works reliably even in noisy circuits.

According to an embodiment, a first sense connection structure between the first load pad and the current sense unit has a first inductance, a second sense connection structure between the current sense unit and the load base structure or between the current sense unit and one of the second load pads has a second inductance, a load connection structure between one of the second load pads and the load base structure has a third inductance, and a difference between the third inductance and the sum of the first and second inductances is less than 50% of the sum of the first, the second and the third inductances.

With the comparatively low difference between the parasitic inductances effective for the load transistor cells and the sense transistor cells, the sense current rather precisely images the dynamic response of the load current. A true overload condition can be distinguished with high reliability from non-critical transients.

For example, the first and second sense connection structures and the load connection structures include bond wires of the same material and cross-sectional area. Then, the first sense connection structure between the first load pad and the current sense unit has a first length, the second sense connection structure between the current sense unit and the load base structure or between the current sense unit and one of the second load pads has a second length, the load connection structure between one of the second load pads and the load base structure has a third length, and a difference between the third length and the sum of the first and second lengths is less than 50% of the sum of the first, the second and the third lengths.

In particular, a shortest distance between the first load pad and the current sense unit can be smaller than a shortest distance between the first load pad and the load base structure.

According to an embodiment, the semiconductor assembly may include at least two of the semiconductor switching devices wherein the current sense unit is electrically connected between the load base structure and the first load pad of one of the semiconductor switching devices.

For example, the semiconductor assembly may include fewer current sense units than semiconductor switching devices, and at least one of the semiconductor switching devices is not connected to a current sense unit. In particular, the semiconductor assembly may include one single current sense unit, and all but one the semiconductor switching devices are without connection to a current sense unit.

According to another embodiment, the semiconductor assembly may include at least two of the semiconductor switching devices and at least two of the current sense units, wherein a first one of the current sense units is electrically connected between the load base structure and the first load pad of a first one of the semiconductor switching devices, and wherein a second one of the current sense units is electrically connected between the load base structure and the first load pad of a second one of the semiconductor switching devices.

In particular, the semiconductor assembly may include the same number of semiconductor switching devices as current sense units, each of the current sense units being electrically connected between the load base structure and a first load pad of one of the semiconductor switching devices.

Another embodiment of the present disclosure relates to a semiconductor assembly that may include a semiconductor switching device and a current sense unit. The semiconductor switching device may include a drain structure and one or more array units, wherein each array unit includes a load pad and a plurality of transistor cells electrically connected in parallel between the load pad of the array unit and the drain structure. The current sense unit is electrically connected to a first one of the load pads. L_{SNS}*dI_{SNS}/dt of a sense current I_{SNS} flowing between the first load pad and the current sense unit and of a sense inductivity L_{SNS} effective for the sense current I_{SNS} is at least 1.5% of L_{LD}*dI_{LD}/dt of a total load current I_{LD} flowing between the semiconductor switching device and a load and of a load inductivity L_{LD} effective for the total load current I_{LD}.

With the comparatively low difference between the parasitic inductances effective for the load transistor cells and the sense transistor cells, the sense current rather precisely images the dynamic response of the load current. A true overload condition can be distinguished with high reliability from non-critical transients.

Another embodiment of the present disclosure relates to a semiconductor assembly that may include a semiconductor switching device and a current sense unit. The semiconductor switching device may include a drain structure and one or more array units, wherein each array unit includes a load pad and a plurality of transistor cells electrically connected in parallel between the load pad of the array unit and the drain structure. The current sense unit is electrically connected to a first one of the load pads. In a nominal on-state of the semiconductor switching device, a sense current I_{SNS} flowing between the first load pad and the current sense unit may be in a range from 0.5A to 20A, e.g. in a range from 1A to 10A.

The nominal on-state of the semiconductor switching device is to be understood as an operational mode of the semiconductor switching device within the SOA, wherein the load current does not exceed an allowable maximum nominal load current defined for the switching device, e.g., in a data sheet. The nominal load current may be, e.g., the maximum continuous collector current of an IGBT or the maximum continuous drain current of an MOSFET, by way of example. The nominal on-state does not include the operation of the semiconductor switching device in a short-circuit mode or under any other overcurrent conditions for which a load current greater than the nominal load current is allowed only for a short time or for periodic intervals.

The current sense unit may be designed to reliably handle overcurrent events or short circuit events where the current level may be a multiple of the nominal current, e.g. twice, three times or up to five times of the nominal current.

In particular, the current sense unit may be designed to reliably handle short-time sense currents up to 20A, e.g. up to 30A or even more and a continuous sense current up to 10A or up to 20A.

The high sense current may reliably prevent interpretation of transients as would-be overcurrent conditions.

According to an embodiment, the semiconductor assembly may be configured such that in the on-state of the semiconductor switching device, the sense current I_{SNS} is at least 1% of the total load current I_{LD}.

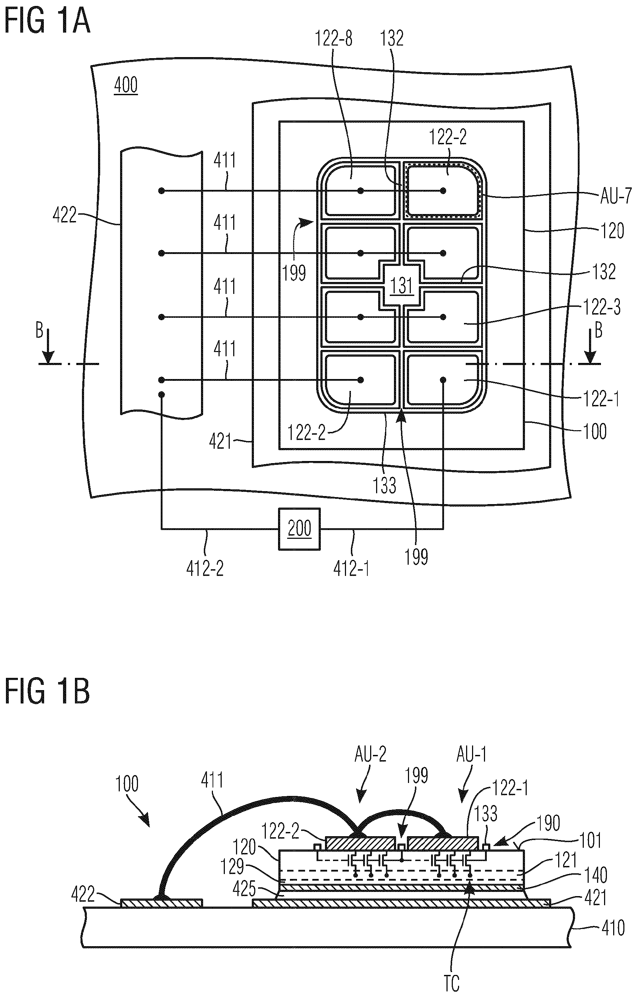

FIGS. 1A-1B illustrate a portion of a semiconductor assembly 400 that includes a semiconductor switching device 100, a load base structure 422 and a current sense unit 200.

The semiconductor switching device 100 may be present as semiconductor die, e.g., as bare die of a MOSFET or an IGBT, e.g. of a reverse blocking IGBT or of an RC-IGBT (reverse conducting IGBT), wherein the semiconductor die includes a semiconductor body 120 mainly formed from a single crystalline semiconductor material, for example silicon (Si), germanium (Ge), a silicon-germanium crystal (SiGe), silicon carbide (SiC), gallium nitride (GaN) or gallium arsenide (GaAs), by way of example.

The semiconductor body 120 has a first surface 101 on the front side. In a horizontal plane parallel to the first surface 101, the semiconductor body 120 may have a rectangular shape. A normal to the first surface 101 defines a vertical direction, and directions orthogonal to the vertical direction are lateral directions (horizontal directions). The semiconductor body 120 includes a drain structure 121 that may extend horizontally through the semiconductor body 120. The drain structure 121 may include a heavily doped contact layer 129 formed along a second surface on the backside of the semiconductor body 120.

A front side metallization on the first surface 101 includes one or more load pads 122, a gate pad 131 and gate connection lines 132 electrically connected with the gate pad 132. Pad gaps 199 laterally separate adjacent load pads 122 completely or at least partially from each other. The gate connection lines 132 are formed in the pad gaps 199. A gate runner 133 may form a closed frame or open frame around the one or more load pads 122. A backside metallization 140 is formed on the second surface on the backside of the semiconductor body 120. The backside metallization 140 and the contact layer 129 form a low-resistive ohmic contact.

The semiconductor switching device 100 includes a plurality of array units AU. Each array unit AU includes one of the load pads 122 and transistor cells TC. The load paths of the transistors cells TC are electrically connected between the load pad 122 of the respective array unit AU and the drain structure 121. In particular, the load pads 122 and the sources of the transistor cells TC form low-resistive ohmic contacts. The gate runners 133 and the gate connection lines 132 electrically connect the gates of the transistors cells TC with the gate pad 131.

The load pads 122 may include aluminum or copper as the only main constituent or as one of several main constituents. For example, the load pads 122 may include a copper alloy, e.g., a copper aluminum alloy (CuAl) with or without silicon (Si), or an aluminum alloy, e.g. AlSi or AlSiCu.

The switching assembly 400 further includes a module substrate 410. The module substrate 410 may be formed from a ceramic material or a resin. Laterally separated conductive structures may be formed on a mounting surface on a components side of the module substrate 410. The conductive structures include a collector plate 421 and a load base structure 422. The collector plate 421 and the load base structure 422 are thin, flat metallic plates, e.g. from copper or a copper alloy.

The semiconductor switching device 100 is soldered or sintered onto the collector plate 421. In the illustrated example, a solder layer 140 formed between the backside metallization 140 and the collector plate 421 connects the semiconductor switching device 100 and the module substrate 410.

A first sense connection structure 412-1 electrically connects a first load pad 122-1 and a current sense unit 200. The first load pad 122-1 is laterally separated from adjacent load pads 122, in particular from all directly neighboring second load pads 122-2. A second sense connection structure 412-2 electrically connects the current sense unit 200 and the load base structure 422. Load connection structures 411 electrically connect second load pads 122-2 and the load base structure 422. Each of the first sense connection structure 412-1, the second sense connection structure 412-2, and the load connection structures 411 may include one or more bond wires, metal clips or strip lines.

In an on-state of the semiconductor switching device 100, a sense current I_{SNS} flowing between the first load pad 122-1 and the current sense unit 200 may be, e.g., up to 10A.

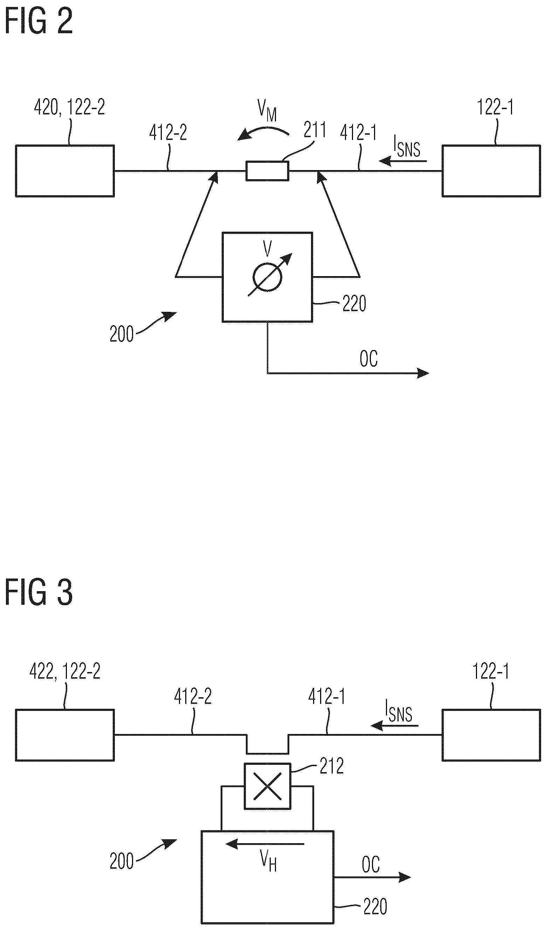

In FIG. 2 the current sense unit 200 includes a further semiconductor die and a resistive shunt 211 electrically connecting the first sense connection structure 412-1 and the second sense connection structure 412-2. The resistive shunt 211 may be a metal strip conductor formed on a surface of the further semiconductor die. The sense current I_{SNS} tapped from the first load pad 122-1 flows through the resistive shunt 211 and produces a voltage drop Vm across the resistive shunt 211. The first sense connection structure 412-1, the second sense connection structure 412-2, and the resistive shunt 211 are designed to carry a continuous sense current of up to 10A and short overcurrents of at least twice of the continuous sense current.

The further semiconductor die may include an overcurrent detection circuit 220 that measures the voltage drop Vm across the resistive shunt 211, compares the measured voltage drop Vm with a predetermined threshold voltage and outputs an active overcurrent signal OC, when the measured voltage drop Vm exceeds the predetermined threshold voltage.

In FIG. 3 the current sense unit 200 includes a semiconductor die with a magnetic field sensor 212 adapted to sense the magnetic field strength of a magnetic field generated by the sense current I_{SNS} tapped from the first load pad 122-1. The semiconductor die includes an overcurrent detection circuit 220 compares a voltage VH induced by the magnetic field of the sense current I_{SNS}, compares the induced voltage VH with a predetermined threshold voltage and outputs an active overcurrent signal OC, when the induced voltage VH exceeds the predetermined threshold voltage. The first sense connection structure 412-1 and the second sense connection structure 412-2 are designed to carry a continuous sense current of up to 10A. The magnetic field sensor 212 is designed to be sensitive for continuous sense currents up to 10A and overcurrents of at least twice of the continuous sense current.

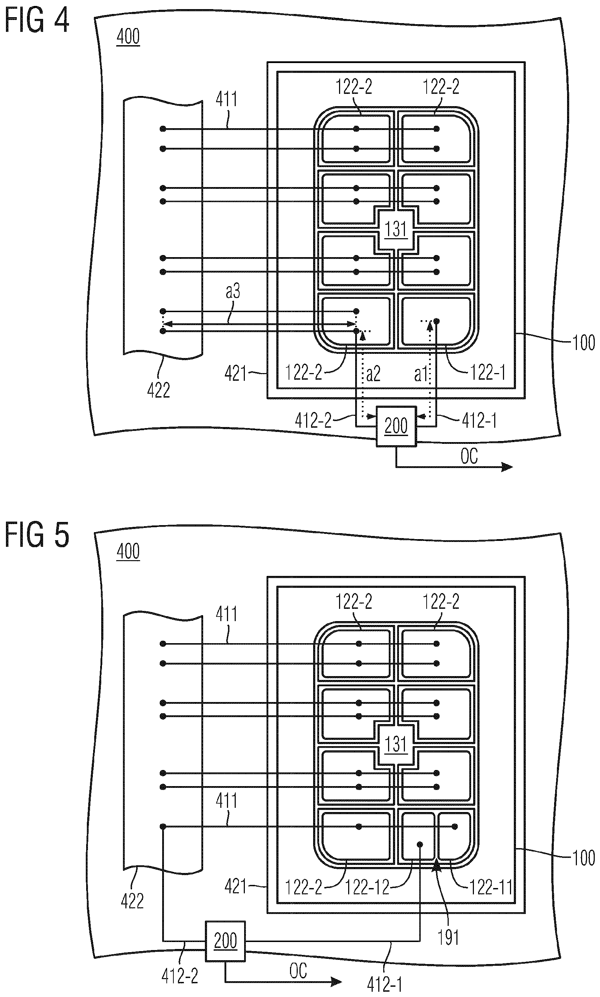

In FIG. 4, the second sense connection structure 412-2 is in direct contact with the current sense unit 220 and a second load pad 122-2. A load connection structure 411 electrically connects the load base structure 422 and the second load pad 122-2 to which the second sense connection structure 412-2 is connected.

The first and second sense connection structures 412-1, 412-2 and the load connection structures 411 include bond wires of the same material and cross-sectional area. Then, the first sense connection structure 412-1 has a first length a1, the second sense connection structure 412-2 has a second length a2, the load connection structures 411 between one of the second load pads and the load base structure 422 have a mean third length a3, and a difference between the mean third length a3 and the sum a1+a2 of the first and second lengths is less than 50% of the sum a1+a2+a3 of the first, the second and the mean third lengths. As a consequence, the difference between the inductance of one of the load connection structures 411 and the total inductance of the first and second sense connection structures 412-1, 412-2 is comparatively low.

In FIG. 5, an auxiliary gap 191 laterally divides the first load pad 122-1 into a first load pad portion 122-11 and a second load pad portion 122-12. A load connection structure 411 directly connects the first load pad portion 122-11 and the load base structure 422. A first sense connection structure 412-1 electrically connects the second load pad portion 122-12 and the current sense unit 200. A second sense connection structure 412-2 directly connects the current sense unit 200 and the load base structure 422. Dividing the first load pad 122-1 reduces the maximum sense current I_{SNS} and prevents the current sense unit 200 from being damaged by high current under overcurrent conditions.

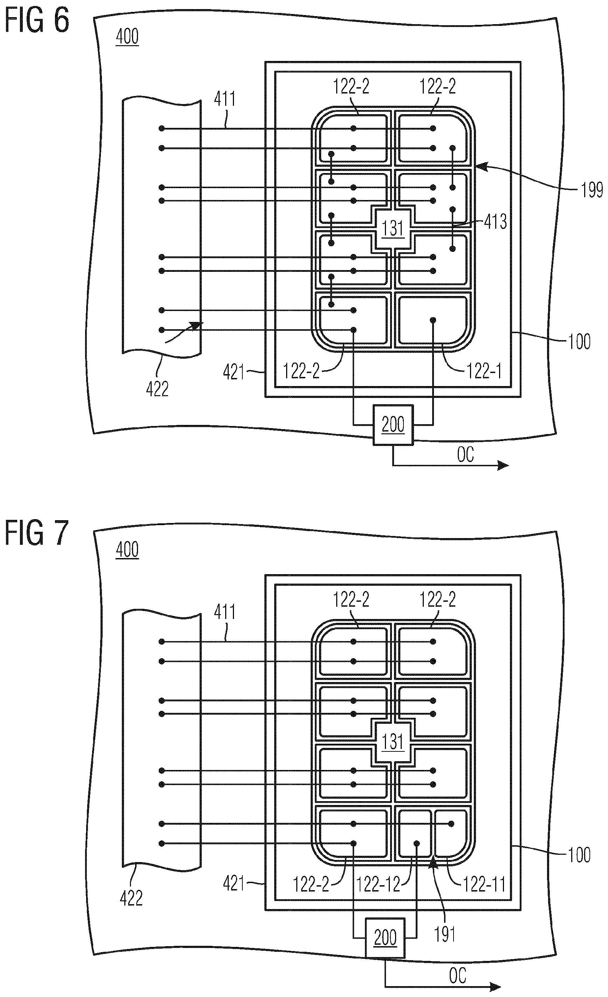

In FIG. 6, inter pad connections 413 directly connect neighboring second load pads 122-2 that are not connected through load connection structures 411. The inter pad connections 413 can reduce parasitic inductances in semiconductor switching devices 100 with multiple load pads 122-2. Each inter pad connection 413 may include one or more bond wires, a suitably formed metal clip or one or more interruptions in the pad gaps 199. The inter pad connections 413 are without connection to the first load pad 122-1. In other words, only the first sense connection structure 412-1 is in direct contact with the exposed surface of the first load pad 122-1.

In FIG. 7, an auxiliary gap 191 laterally divides the first load pad 122-1 into a first load pad portion 122-11 and a second load pad portion 122-12. A load connection structure 411 directly connects the first load pad portion 122-11 and the load base structure 422. A first sense connection structure 412-1 electrically connects the second load pad portion 122-12 and the current sense unit 200. A second sense connection structure 412-2 directly connects the current sense unit 200 and a second load pad 122-2. A load connection structure 411 electrically connects the load base structure 422 and that second load pad 122-2 to which the second sense connection structure 412-2 is connected.

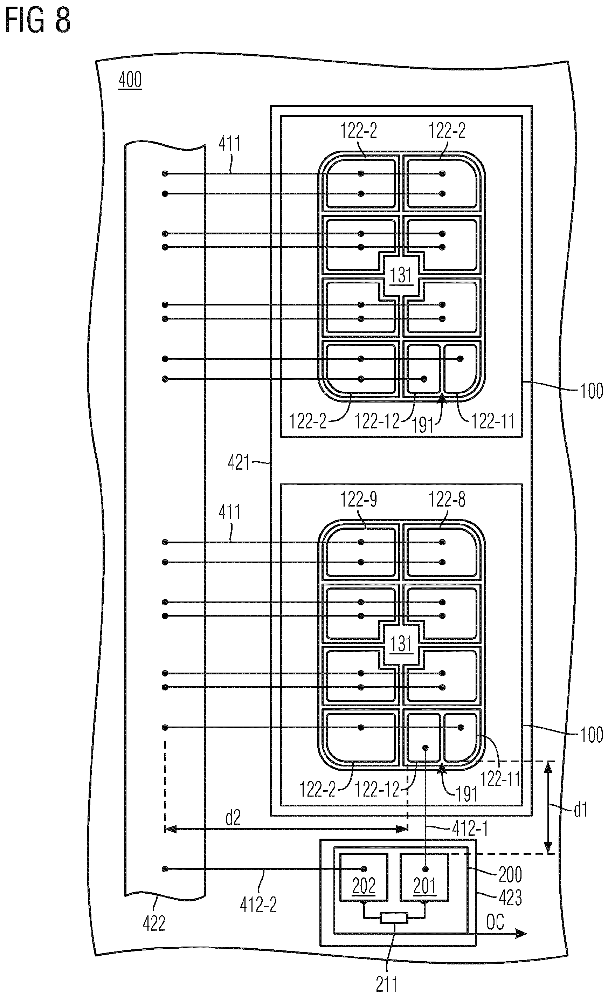

FIG. 8 shows two semiconductor switching devices 100 of the same type and one current sense unit 200 electrically connected between the load base structure 422 and the first load pad 122-1 of one of the semiconductor switching devices 100 of the semiconductor assembly 400. The semiconductor switching devices 100 electrically connected in parallel and are soldered or sintered onto the same collector plate 421.

The current sense unit 200 includes a semiconductor die soldered or sintered on a sense base structure 423. A first terminal 201 and a second terminal 202 are formed on a front side of the semiconductor die. The first terminal 201 and the second terminal 202 may be pads suitable as base for wire bonds. A resistive shunt 211 is electrically connected between the two terminals 201, 202.

An auxiliary gap 191 laterally divides the first load pad 122-1 into a first load pad portion 122-11 and a second load pad portion 122-12. A load connection structure 411 directly connects the first load pad portion 122-11 and the load base structure 422. A first sense connection structure 412-1 directly connects the second load pad portion 122-12 and the first terminal 201. A second sense connection structure 412-2 directly connects the second terminal 202 and the load base structure 422.

A shortest distance d1 between the second load pad portion 122-12 and the first terminal 201 is smaller than a shortest distance d2 between the second load pad portion 122-12 and the connections on the load base structure 422, in particular between the second load pad portion 122-12 and that bond food, that connects the direct load connection 411 of the first load pad portion 122-11 with the load base structure 422.

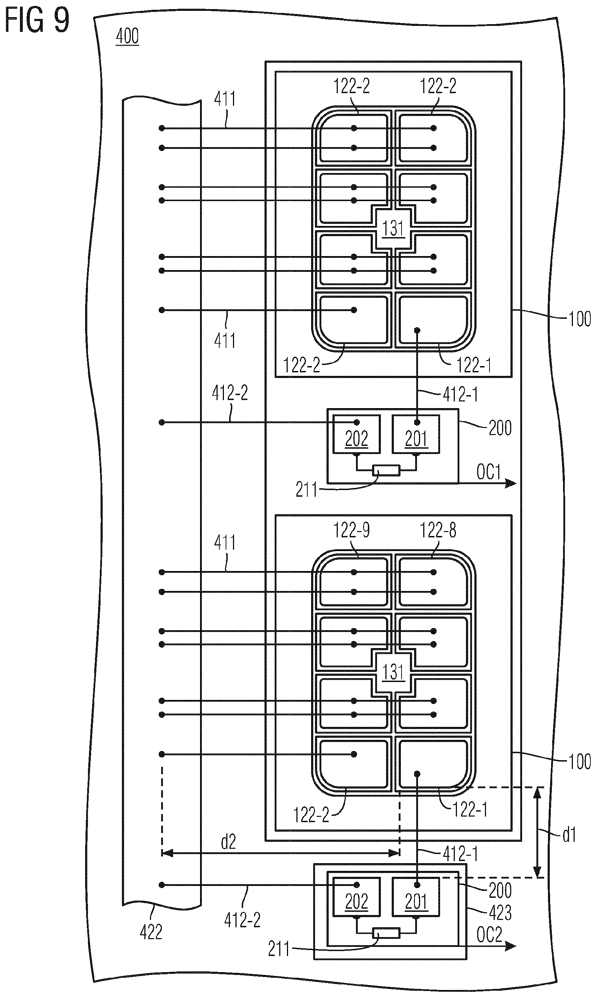

FIG. 9 shows a semiconductor assembly 400 that includes at least two semiconductor switching devices 100 and at least two current sense units 200. A first current sense units 200 is electrically connected between the load base structure 422 and the first load pad 122-1 of a first one of the semiconductor switching devices 100 a second current sense unit 200 is electrically connected between the load base structure 422 and the first load pad 122-1 of a second one of the semiconductor switching devices 100.

## Claims

1. A semiconductor assembly (400), comprising:
a module substrate (410), wherein a conductive load base structure (422) and a collector plate (421) are formed on a component side of the module substrate (410);
a semiconductor switching device (100) comprising a backside metallization (140), a drain structure (121) and a plurality of array units (AU), wherein each array unit (AU) comprises a load pad (122) and a plurality of transistor cells (TC) electrically connected in parallel between the load pad (122) of the array unit (AU) and the drain structure (121), and wherein the backside metallization (140) and the collector plate (421) of the module substrate (410) are electrically connected; and
a current sense unit (200) electrically connected between a first one of the load pads (122-1) and the load base structure (422).

2. The semiconductor assembly according to the preceding claim,
wherein in each array unit (AU), the transistor cells (TC) are formed directly between the load pad (122) and the drain structure (121).

3. The semiconductor assembly according to any of the preceding claims,
wherein the current sense unit (200) comprises a resistive shunt (211) electrically connected between the first load pad (122-1) and the load base structure (422) or between the first load pad (122-1) and one of second ones of the load pads (122-2).

4. The semiconductor assembly according to any of the preceding claims,
wherein the current sense unit (200) comprises a magnetic field sensor (212) configured to sense a magnetic field caused by a current flowing between the first load pad (122-1) and the load base structure (422) or between the first load pad (122-1) and one of second ones of the load pads (122-2).

5. The semiconductor assembly according to any of the preceding claims, further comprising:
one or more load connection structures (411), wherein each load connection structure (411) electrically connects the load base structure (422) and one or more of second ones of the load pads (122-2).

6. The semiconductor assembly according to the preceding claim,
wherein at least one of the load connection structures (411) electrically connects the load base structure (422) and two of the second load pads (122-2).

7. The semiconductor assembly (100) according to any of the preceding claims, further comprising:
a gate pad (131), wherein the gate pad (131) is laterally separated from the load pads (122), and
gate connection lines (132) electrically connected with the gate pad (132), wherein the gate connection lines (132) are formed in pad gaps (199) between neighboring ones of the load pads (122).

8. The semiconductor assembly (100) according to any of the preceding claims,
wherein a first terminal (201) of the current sense unit (200) is directly connected to the first load pad (122-1) and a second terminal (202) of the current sense unit (200) is directly connected to the load base structure (422).

9. The semiconductor assembly (100) according to any of claims 1 to 7,
wherein a first terminal (201) of the current sense unit (200) is directly connected to the first load pad (122-1) and a second terminal (202) of the current sense unit (200) is directly connected to one of second ones of the load pads (122-2).

10. The semiconductor assembly according to the preceding claim,
wherein the current sense unit (200) comprises an overcurrent detection circuit (220) configured to evaluate a current flowing through the current sense unit (200) between the first load pad (122-1) and the load base structure (422) or between the first load pad (122-1) and one of second ones of the load pads (122-2).

11. The semiconductor assembly according to any of the preceding claims,
wherein a first sense connection structure (412-1) between the first load pad (122-1) and the current sense unit (200) has a first inductance, a second sense connection structure (412-2) between the current sense unit (200) and the load base structure (422) or between the current sense unit (200) and one of the second load pads (122-2) has a second inductance, a direct load connection structure (411) between one of second ones of the load pads (122-2) and the load base structure (422) has a third inductance, and wherein a difference between the third inductance and the sum of the first and second inductances is less than 50% of the sum of the first, the second and the third inductances.

12. The semiconductor assembly according to any of the preceding claims,
wherein the semiconductor assembly (400) comprises at least two of the semiconductor switching devices (100) and wherein the current sense unit (200) is electrically connected between the load base structure (422) and the first load pad (122-1) of one of the semiconductor switching devices (100).

13. The semiconductor assembly according to any of claims 1 to 11,
wherein the semiconductor assembly (400) comprises at least two of the semiconductor switching devices (100) and at least two of the current sense units (200), wherein a first one of the current sense units (200) is electrically connected between the load base structure (422) and the first load pad (122-1) of a first one of the semiconductor switching devices (100), and wherein a second one of the current sense units (200) is electrically connected between the load base structure (422) and the first load pad (122-1) of a second one of the semiconductor switching devices (100).

14. The semiconductor assembly (400) according to any of the preceding claims,
wherein in a nominal on-state of the semiconductor switching device (100), a sense current I_{SNS} flowing between the first load pad (122-1) and the current sense unit (200) is in a range from 0.5A to 20A.

15. The semiconductor assembly according to the preceding claim,
wherein the semiconductor assembly (400) is configured such that in the on-state of the semiconductor switching device (100) the sense current I_{SNS} is at least 1% of a total load current I_{LD} flowing between the semiconductor switching device (100) and a load.

## Patentansprüche

1. Halbleiteranordnung (400), die Folgendes umfasst:
ein Modulsubstrat (410), wobei eine leitfähige Lastbasisstruktur (422) und eine Kollektorplatte (421) auf einer Komponentenseite des Modulsubstrats (410) gebildet sind;
eine Halbleiterschaltvorrichtung (100), die eine Rückseitenmetallisierung (140), eine Drain-Struktur (121) und eine Vielzahl von Arrayeinheiten (AU) umfasst, wobei jede Arrayeinheit (AU) einen Lastpad (122) und eine Vielzahl von Transistorzellen (TC) umfasst, die elektrisch parallel zwischen dem Lastpad (122) der Arrayeinheit (AU) und der Drain-Struktur (121) verbunden sind, und wobei die Rückseitenmetallisierung (140) und das Kollektorplatte (421) des Modulsubstrats (410) elektrisch verbunden sind; und
eine Strommesseinheit (200), die elektrisch zwischen einem ersten der Lastpads (122-1) und der Lastbasisstruktur (422) verbunden ist.

2. Halbleiteranordnung nach dem vorhergehenden Anspruch,
wobei in jeder Arrayeinheit (AU) die Transistorzellen (TC) direkt zwischen dem Lastpad (122) und der Drain-Struktur (121) gebildet sind.

3. Halbleiteranordnung nach einem der vorhergehenden Ansprüche,
wobei die Strommesseinheit (200) einen ohmschen Shunt (211) umfasst, der elektrisch zwischen dem ersten Lastpad (122-1) und der Lastbasisstruktur (422) oder zwischen dem ersten Lastpad (122-1) und einem der zweiten Lastpads (122-2) verbunden ist.

4. Halbleiteranordnung nach einem der vorhergehenden Ansprüche,
wobei die Strommesseinheit (200) einen Magnetfeldsensor (212) umfasst, der dazu ausgelegt ist, ein Magnetfeld zu erfassen, das durch einen Strom verursacht wird, der zwischen dem ersten Lastpad (122-1) und der Lastbasisstruktur (422) oder zwischen dem ersten Lastpad (122-1) und einem der zweiten Lastpads (122-2) fließt.

5. Halbleiteranordnung nach einem der vorhergehenden Ansprüche, die ferner Folgendes umfasst:
eine oder mehrere Lastverbindungsstrukturen (411), wobei jede Lastverbindungsstruktur (411) die Lastbasisstruktur (422) und eines oder mehrere von zweiten der Lastpads (122-2) elektrisch verbindet.

6. Halbleiteranordnung nach dem vorhergehenden Anspruch,
wobei mindestens eine der Lastverbindungsstrukturen (411) die Lastbasisstruktur (422) und zwei der zweiten Lastpads (122-2) elektrisch verbindet.

7. Halbleiteranordnung (100) nach einem der vorhergehenden Ansprüche, die ferner Folgendes umfasst:
ein Gate-Pad (131), wobei das Gate-Pad (131) lateral von den Lastpads (122) getrennt ist, und
Gate-Verbindungsleitungen (132), die elektrisch mit dem Gate-Pad (132) verbunden sind, wobei die Gate-Verbindungsleitungen (132) in Padlücken (199) zwischen benachbarten der Lastpads (122) gebildet sind.

8. Halbleiteranordnung (100) nach einem der vorhergehenden Ansprüche,
wobei ein erster Anschluss (201) der Strommesseinheit (200) direkt mit dem ersten Lastpad (122-1) verbunden ist und ein zweiter Anschluss (202) der Strommesseinheit (200) direkt mit der Lastbasisstruktur (422) verbunden ist.

9. Halbleiteranordnung (100) nach einem der Ansprüche 1 bis 7,
wobei ein erster Anschluss (201) der Strommesseinheit (200) direkt mit dem ersten Lastpad (122-1) verbunden ist und ein zweiter Anschluss (202) der Strommesseinheit (200) direkt mit einem der zweiten Lastpads (122-2) verbunden ist.

10. Halbleiteranordnung nach dem vorhergehenden Anspruch,
wobei die Strommesseinheit (200) eine Überstromdetektionsschaltung (220) umfasst, die dazu ausgelegt ist, einen Strom zu bewerten, der durch die Strommesseinheit (200) zwischen dem ersten Lastpad (122-1) und der Lastbasisstruktur (422) oder zwischen dem ersten Lastpad (122-1) und einem der zweiten Lastpads (122-2) fließt.

11. Halbleiteranordnung nach einem der vorhergehenden Ansprüche,
wobei eine erste Erfassungsverbindungsstruktur (412-1) zwischen dem ersten Lastpad (122-1) und der Strommesseinheit (200) eine erste Induktivität aufweist, eine zweite Erfassungsverbindungsstruktur (412-2) zwischen der Strommesseinheit (200) und der Lastbasisstruktur (422) oder zwischen der Strommesseinheit (200) und einem der zweiten Lastpads (122-2) eine zweite Induktivität aufweist, eine direkte Lastverbindungsstruktur (411) zwischen einem der zweiten der Lastpads (122-2) und der Lastbasisstruktur (422) eine dritte Induktivität aufweist, und wobei eine Differenz zwischen der dritten Induktivität und der Summe der ersten und der zweiten Induktivität weniger als 50 % der Summe der ersten, der zweiten und der dritten Induktivität beträgt.

12. Halbleiteranordnung nach einem der vorhergehenden Ansprüche,
wobei die Halbleiteranordnung (400) mindestens zwei der Halbleiterschaltvorrichtungen (100) umfasst, und wobei die Strommesseinheit (200) elektrisch zwischen der Lastbasisstruktur (422) und dem ersten Lastpad (122-1) einer der Halbleiterschaltvorrichtungen (100) verbunden ist.

13. Halbleiteranordnung nach einem der Ansprüche 1 bis 11,
wobei die Halbleiteranordnung (400) mindestens zwei der Halbleiterschaltvorrichtungen (100) und mindestens zwei der Strommesseinheiten (200) umfasst, wobei eine erste der Strommesseinheiten (200) elektrisch zwischen der Lastbasisstruktur (422) und dem ersten Lastpad (122-1) einer ersten der Halbleiterschaltvorrichtungen (100) verbunden ist, und wobei eine zweite der Strommesseinheiten (200) elektrisch zwischen der Lastbasisstruktur (422) und dem ersten Lastpad (122-1) einer zweiten der Halbleiterschaltvorrichtungen (100) verbunden ist.

14. Halbleiteranordnung (400) nach einem der vorhergehenden Ansprüche,
wobei in einem nominalen Einschaltzustand der Halbleiterschaltvorrichtung (100) ein Erfassungsstrom I_{SNS}, der zwischen dem ersten Lastpad (122-1) und der Strommesseinheit (200) fließt, in einem Bereich von 0,5 A bis 20 A liegt.

15. Halbleiteranordnung nach dem vorhergehenden Anspruch,
wobei die Halbleiteranordnung (400) so ausgelegt ist, dass im eingeschalteten Zustand der Halbleiterschaltvorrichtung (100) der Erfassungsstrom I_{SNS} mindestens 1 % eines Gesamtlaststroms I_{LD} beträgt, der zwischen der Halbleiterschaltvorrichtung (100) und einer Last fließt.

## Revendications

1. Un ensemble (400) à semiconducteur, comprenant :
un substrat (410) de module, dans lequel une structure (422) conductrice de base de charge et une plaque (421) de collecteur sont formées sur une face de composant du substrat (410) de module ;
un dispositif (100) de commutation à semiconducteur comprenant une métallisation (140) de face arrière, une structure (121) de drain et une pluralité d'unités (AU) de réseau, dans lequel chaque unité (AU) de réseau comprend un chemin (122) de charge et une pluralité de cellules (TC) de transistor montées électriquement en parallèle entre le chemin (122) de charge de l'unité (AU) de réseau et la structure (121) de drain, et dans lequel la métallisation (140) de face arrière et la plaque (421) de collecteur du substrat (410) de module sont connectées électriquement ; et
une unité (200) de détection du courant montée électriquement entre un premier des chemins (122-1) de charge et la structure (422) de base de charge.

2. L'ensemble à semiconducteur suivant la revendication précédente,
dans lequel dans chaque unité (AU) de réseau, les cellules (TC) de transistor sont formées directement entre le chemin (122) de charge et la structure (121) de drain.

3. L'ensemble à semiconducteur suivant l'une quelconque des revendications précédentes,
dans lequel l'unité (200) de détection de courant comprend un shunt (211) résistif monté électriquement entre le premier chemin (122-1) de charge et la structure (422) de base de charge ou entre le premier chemin (122-1) de charge et l'un des deuxièmes chemins (122-2) de charge.

4. L'ensemble à semiconducteur suivant l'une quelconque des revendications précédentes,
dans lequel l'unité (200) de détection de courant comprend un capteur (212) de champ magnétique configuré pour détecter un champ magnétique provoqué par un flux de courant entre le premier chemin (122-1) de charge et la structure (422) de base de charge ou entre le premier chemin (122-1) de charge et l'un des deuxièmes chemins (122-2) de charge.

5. L'ensemble à semiconducteur suivant l'une quelconque des revendications précédentes, comprenant en outre :
une ou plusieurs structures (411) de connexion de charge, dans lequel chaque structure (411) de connexion de charge connecte la structure (422) de base de charge et un ou plusieurs des deuxièmes chemins (122-2) de charge.

6. L'ensemble à semiconducteur suivant la revendication précédente,
dans lequel au moins l'une des structures (411) de connexion de charge connecte électriquement la structure (422) de base de charge et deux des deuxièmes chemins (122-2) de charge.

7. L'ensemble (100) à semiconducteur suivant l'une quelconque des revendications précédentes, comprenant en outre :
une plage (131) de grille, dans lequel la plage (131) de grille est séparée latéralement des plages (122) de charge, et
des lignes (132) de connexion de grille connectées électriquement à la plage (132) de grille, dans lequel les lignes (132) de connexion de grille sont formées dans des intervalles (199) de plage entre des chemins voisins des chemins (122) de charge.

8. L'ensemble (100) à semiconducteur suivant l'une quelconque des revendications précédentes,
dans lequel une première borne (201) de l'unité (200) de détection de courant est connectée directement au premier chemin (122-1) de charge et une deuxième borne (202) de l'unité (200) de détection de courant est connectée directement à la structure (422) de base de charge.

9. L'ensemble (100) à semiconducteur suivant l'une quelconque des revendications 1 à 7,
dans lequel une première borne (201) de l'unité (200) de détection de courant est connectée directement au premier chemin (122-1) de charge et une deuxième borne (202) de l'unité (200) de détection de courant est connectée directement à l'un des deuxièmes chemins (122-2) de charge.

10. L'ensemble à semiconducteur suivant la revendication précédente,
dans lequel l'unité (200) de détection de courant comprend un circuit (220) de détection de surcourant configuré pour évaluer un flux de courant passant dans l'unité (200) de détection de courant entre le premier chemin (122-1) de charge et la structure (422) de base de charge ou entre le premier chemin (122-1) de charge et l'un des deuxièmes chemins (122-2) de charge.

11. L'ensemble à semiconducteur suivant l'une quelconque des revendications précédentes,
dans lequel une première structure (412-1) de connexion de détection entre le premier chemin (122-1) de charge et l'unité (200) de détection de courant a une première inductance, une deuxième structure (412-2) de connexion de détection entre l'unité (200) de détection de courant et la structure (422) de base de charge entre l'unité (200) de détection de courant et l'un des deuxièmes chemins (122-2) de charge a une deuxième inductance, une structure (411) de connexion de charge directe entre l'un des deuxièmes chemins (122-2) de charge et la structure (422) de base de charge a une troisième inductance, et dans lequel une différence entre la troisième inductance et la somme de la première et de la deuxième inductances est inférieure à 50 % de la somme des première, deuxième et troisième inductances.

12. L'ensemble à semiconducteur suivant l'une quelconque des revendications précédentes,
dans lequel l'ensemble (400) à semiconducteur comprend au moins deux des dispositifs (100) de commutation à semiconducteur et dans lequel l'unité (200) de détection de courant est montée électriquement entre la structure (422) de base de charge et le premier chemin (122-1) de charge de l'un des dispositifs (100) de commutation à semiconducteur.

13. L'ensemble à semiconducteur suivant l'une quelconque des revendications 1 à 11,
dans lequel l'ensemble (400) à semiconducteur comprend au moins deux des dispositifs (100) de commutation à semiconducteur et au moins deux des unités (200) de détection de courant, dans lequel une première des deux unités (200) de détection de courant est montée électriquement entre la structure (422) de base de charge et le premier chemin (122-1) de charge d'un premier des dispositifs (100) de commutation à semiconducteur, et dans lequel une deuxième des unités (200) de détection de courant est montée électriquement entre la structure (422) de base de charge et le premier chemin (122-1) de charge d'un deuxième des dispositifs (100) de commutation à semiconducteur.

14. L'ensemble (400) à semiconducteur suivant l'une quelconque des revendications précédentes,
dans lequel, dans un état nominal passant du dispositif (100) de commutation à semiconducteur, un courant I_{SNS} de détection passant entre le premier chemin (122-1) de charge et l'unité (200) de détection de courant est dans une plage de 0,5 A à 20 A.

15. L'ensemble à semiconducteur suivant la revendication précédente,
dans lequel l'ensemble (400) à semiconducteur est configuré de manière à ce que, dans l'état passant du dispositif (100) de commutation à semiconducteur, le courant I_{SNS} de détection représente au moins 1 % d'un courant I_{LD} total de charge passant entre le dispositif (100) de commutation à semiconducteur et de charge.
